(19) **Europäisches Patentamt**
**European Patent Office**
**Office européen des brevets**

(11) **EP 1 082 696 B1**

(12) **EUROPEAN PATENT SPECIFICATION**

(45) Date of publication and mention
of the grant of the patent:
**02.12.2009 Bulletin 2009/49**

(51) Int Cl.:
*G06F 3/042* (2006.01)        *G06F 3/00* (2006.01)
*G06F 3/033* (2006.01)        *H03J 1/00* (2006.01)

(21) Application number: **00912585.7**

(86) International application number:
**PCT/EP2000/002092**

(22) Date of filing: **09.03.2000**

(87) International publication number:
**WO 2000/060534 (12.10.2000 Gazette 2000/41)**

(54) **REMOTE CONTROL FOR DISPLAY APPARATUS**

FERNSTEUERUNGSANORDNUNG FÜR EINE ANZEIGEVORRICHTUNG

TELECOMMANDE POUR DISPOSITIF D'AFFICHAGE

(84) Designated Contracting States:
**DE ES FR GB IT**

(30) Priority: **31.03.1999 EP 99200982**

(43) Date of publication of application:
**14.03.2001 Bulletin 2001/11**

(73) Proprietor: **Koninklijke Philips Electronics N.V.**
**5621 BA Eindhoven (NL)**

(72) Inventors:
• **DUIJVE, Rene**
**NL-5656 AA Eindhoven (NL)**
• **BAUMER, Stefan, M., B.**
**NL-5656 AA Eindhoven (NL)**
• **MIMNAGH-KELLEHER, Gillian, A.**
**NL-5656 AA Eindhoven (NL)**

(74) Representative: **Groenendaal, Antonius W. M. et al**
**Philips**
**Intellectual Property & Standards**
**P.O. Box 220**
**5600 AE Eindhoven (NL)**

(56) References cited:
**EP-A- 0 767 443      EP-A- 0 838 751**
**US-A- 5 138 304      US-A- 5 535 147**

• **PATENT ABSTRACTS OF JAPAN vol. 1995, no. 08, 29 September 1995 (1995-09-29) -& JP 07 121293 A (NIPPON TELEGR & TELEPH CORP), 12 May 1995 (1995-05-12)**
• **PATENT ABSTRACTS OF JAPAN vol. 1995, no. 10, 30 November 1995 (1995-11-30) & JP 07 191799 A (TOSHIBA CORP), 28 July 1995 (1995-07-28)**

Printed by Jouve, 75001 PARIS (FR)

**Description**

FIELD OF THE INVENTION

The invention relates to a remote control apparatus for controlling a display apparatus, comprising orientation means for detecting a relative movement of the remote control apparatus with respect to the display apparatus.

The invention further relates to a system of a display apparatus and the above remote control apparatus.

BACKGROUND OF THE INVENTION

With the advent of advanced features for television, such as Internet browsing, home shopping and game playing, the user must be enabled to control these new features from the usual viewing distance. For that reason, a remote control is needed which integrates the functions of a conventional remote control and a pointing device, such as a computer mouse. Various solutions have been proposed for this integration. Some of them are based on the technology applied in a light-pen, wherein the moment of detecting a light spot caused by the cathode ray of the display apparatus is compared with the synchronization signals. This solution is only applicable within a limited distance from the display screen. Other solutions are based on an infrared signal which is transmitted by the display apparatus and received by the remote control. For example, US 5,644,126 discloses a system of a display apparatus and a remote control, the display apparatus having a light source, e.g. a photodiode, the light of which is received by the remote control and led through a lattice. The resultant interference pattern is projected onto an array sensor. If the remote control is moved, the interference pattern shifts, which can be detected by means of the array sensor. The movement is then converted to appropriate commands for controlling functions of the display apparatus, e.g. choosing a menu option from an on-screen display menu.

A disadvantage of the known systems is that both the remote control and the display apparatus need to be adapted to achieve the desired functionality. Hence, they do not provide a remote control which can be applied as an add-on to conventional display apparatuses. Furthermore, only relative movements can be detected with the system of US 5,644,126.

EP-A-0 767 443 discloses a method and system for tracking attitude of a device, which method includes fixing a two-dimensional array of photosensors to the device and using the array to form a reference frame and a sample frame of images. The fields of view of the sample and reference frames largely overlap, so that there are common imaged features from frame to frame. Sample frames are correlated with the reference frame to detect differences in location of the common features. Based upon detection of correlations of features, an attitudinal signal indicative of pitch, yaw, and/or roll is generated. The attitudinal signal may be used to manipulate a screen cursor of a display system, such as a remote interactive video system (RIVS).

JP 07 121 293 discloses a method to input an indication point and position information on an indicating person. On a display screen, a marker is put in each determined frame and its image is picked up by a camera part, a marker extracting process part extracts only the marker and a coordinate position arithmetic process part detects the coordinates of the indication point and the position of the indicating person from the display screen. When the indicating person makes an indication, an IR pulse pattern generation part generates a specific IR pulse with the output of an indication detection part and an IR optical transmission and reception part sends it out to a display-side remote controller reception part.

EP-A-0 838 751 discloses an interactive desktop system comprising a work surface, a video projector for displaying images in a display area, a camera for capturing images present on the work surface, and an image processing computer coupled to the projector and to the camera, and adjustment means for adjusting, in response to user action, the field of view of the camera.

US-A-5,138,304 discloses a technique for interaction with a projected video image with a light pen and/or target marks on the projection screen in which light reflected from the projected image is compared with the video image to detect the position of a spot positioned on the projected image by the light pen and/or the reflection of the target marks. The computer used to generate the video image is then caused to position a cursor in the video image in response to the spot position and/or otherwise modify the generated and/or projected video image.

JP 07 171 799 discloses a wireless non contact type pointing device whereby a noncontact operation is executed regardless of service places by utilizing a gyro capable of detecting shift speed and a shift direction.

US-A-5,535,147 discloses a system for transferring data from a CRT (cathode ray tube) video display monitor on a personal computer to a portable information device such as a multifunction electronic wristwatch. The CRT video display has a video signal generator providing raster scanning of the screen and a program for formatting the binary coded data into blocks of serial data bits, with start bit and stop bit. The blocks of data are supplied to the video signal generator in synchronism with raster scanning of the screen so as to provide an integral number of one or more blocks of data for each vertical frame, and modulated to vary the brightness of the screen and provide light pulses corresponding to presence or absence of binary coded transmitter pulses.; The portable information device is manipulated within line of sight of the CRT screen and has a photosensor to detect light pulses when the photosensor is directed toward the screen. Signals from the photosensor are amplified and filtered to remove ambient light source flicker and extraneous spurious light signals and to convert the receiver pulses to binary coded data blocks varying between high and low logic levels at a preselected pulse repetition rate. The portable information device stores the received data for further use.

OBJECT AND SUMMARY OF THE INVENTION

It is an object of the invention to provide a remote control apparatus of the type defined in the opening paragraph which evades the disadvantages of the remote control apparatuses of the prior art. To this end, the orientation means of the remote control apparatus according to the invention comprise an image sensor and imaging optics for projecting an image on the image sensor, the orientation means being adapted to deduce said movement from a movement of the projected image. The projected image may be of any object, e.g. the display screen, a window or a lamp. If the user moves the remote control apparatus, the projected image will move accordingly. The movement of the projected image can be detected, e.g. by comparing subsequent frames obtained from the image sensor. Software algorithms for detecting and analyzing the movement of the projected image are known per se and will only be discussed in so far as they are relevant for disclosing the invention. Background information may be obtained from, for example:

- A method for processing laser speckle images to extract high-resolution motion, Andrew Houghton, Graham Rees and Peter Ivey Measurement Science & Technology no 8 (1997), pages 611-617 IOP publishing Ltd.
- Linear and rotary encoders using electronic speckle correlation, Ichirou Yamagouchi and Tadashige Fujita, Optical Engineering / December 1991 / vol. 30 No. 12, pages 1862 - 1868.

The movements of the projected image are then translated into appropriate commands for controlling functions of the display apparatus, e.g. a cursor position. An additional advantage of the invention is that rotation can be detected as well.

According to the invention the remote control apparatus further comprises distance measuring means for measuring a distance to an object of which an image is projected on the image sensor, the orientation means being adapted to adjust said relative movement with respect to said distance. For example, the remote control apparatus may be equipped with an auto-focus unit. On the one hand, the auto-focus unit guarantees a sharp projected picture on the image sensor independent of the distance to the projected object. On the other hand, the auto-focus unit may provide information with respect to the distance between the remote control apparatus and said object, which information may be taken into account when determining the sensitivity of the orientation means. For example, when aiming the remote control apparatus at a nearby object, a movement of the remote control apparatus will cause a relatively large movement of the projected image. In that case, the movements may be translated into relatively small cursor movements in comparison to the situation of aiming at a remote object. Techniques for auto-focussing are well known, see for example:

- Digital method for measuring the focus error, by Adolf W. Lohmann, David Mendiovic, and Zeev Zalevsky APPLIED OPTICS / vol. 36. No. 28 / 1 October 1997, pages 7204-7209,
- Speckle techniques for absolute distance measurement, G.E. Hege, H.J. Tiziani, Tech. Messen 54 (6) pages 237 - 242 (1987).

An embodiment of the remote control apparatus according to the invention is characterized in that the remote control apparatus further comprises activation means for activating the orientation means in response to a user command or predetermined event. The activation means may comprise a grip or tilt sensor for detecting the event of picking up the remote control apparatus. Alternatively, the activation means may comprise a button which has to be pressed intentionally to activate the orientation means. Upon activation, the remote control apparatus may perform initialization actions, e.g. to provide a default cursor position. All subsequent movements will then be translated into corresponding cursor movements.

A further embodiment is characterized in that the orientation means are further adapted to recognize an image of the display apparatus. As mentioned before, the display apparatus itself may be conveniently used as an object to aim at. Generally, the display screen is salient in the viewing environment because of its light production. For the purpose of controlling objects displayed on the display screen, specific properties of the display screen may advantageously be taken into account. For example, the dimensions of the screen and/or the picture refresh rate may be used to distinguish the screen from the environment.

A further embodiment is characterized in that the orientation means are further adapted to store properties (dimensions, refresh rate) of the display apparatus. By explicitly storing such properties, e.g. by downloading or explicitly entering them by means of the buttons, the orientation means have a priori knowledge about the projected image of the display apparatus. Hence, confusion caused by, for example, the flickering of lamps or the dimensions of windows can be avoided.

A further embodiment is characterized in that the orientation means are adapted to recognize an icon with predetermined properties on the display of the display apparatus. In this way it is achieved that the display screen can be recognized unambiguously, because the icon can be made unique by means of a specific shape or color combination. The icon may be located in a fixed position, or it may double as the screen cursor.

A further embodiment is characterized in that said predetermined properties comprise a periodic change of predetermined parameters (e.g. color, brightness). In this way, the unambiguous recognition of the display apparatus is further simplified.

A further embodiment is characterized in that the remote control is adapted to decode status information related to the display apparatus from said periodic change. The periodic change of the previous embodiment may be modulated with signals representing said status information. The status information may comprise sensitivity settings, properties of the display apparatus etc.

An embodiment is characterized in that the orientation means are further adapted to determine a relative position of the remote control apparatus with respect to the display apparatus by deducing said relative position from the projected image of the display apparatus. In this way, not only relative positioning, but also absolute positioning becomes feasible, because after recognition of the display screen the necessary properties, such as screen dimensions, are available to the orientation means.

The invention is particularly suitable for television receivers, monitors, (game)computers and presentation devices.

BRIEF DESCRIPTION OF THE DRAWINGS

These and other aspects of the invention are apparent from and will be elucidated, by way of a non-limitative example, with reference to the embodiment(s) described hereinafter. In the drawings,

Figure 1 schematically shows a remote control apparatus and a display apparatus according to the invention,
Figure 2 shows a block diagram of the relevant elements of a remote control apparatus according to the invention,
Figure 3 shows various types of movement which are detected by a remote control apparatus according to the invention,
Figure 4 schematically shows absolute cursor positioning by means of a remote control apparatus according to the invention,
Figure 5 shows an example of information transfer from a display apparatus to a remote control apparatus according to the invention.

DESCRIPTION OF EMBODIMENT

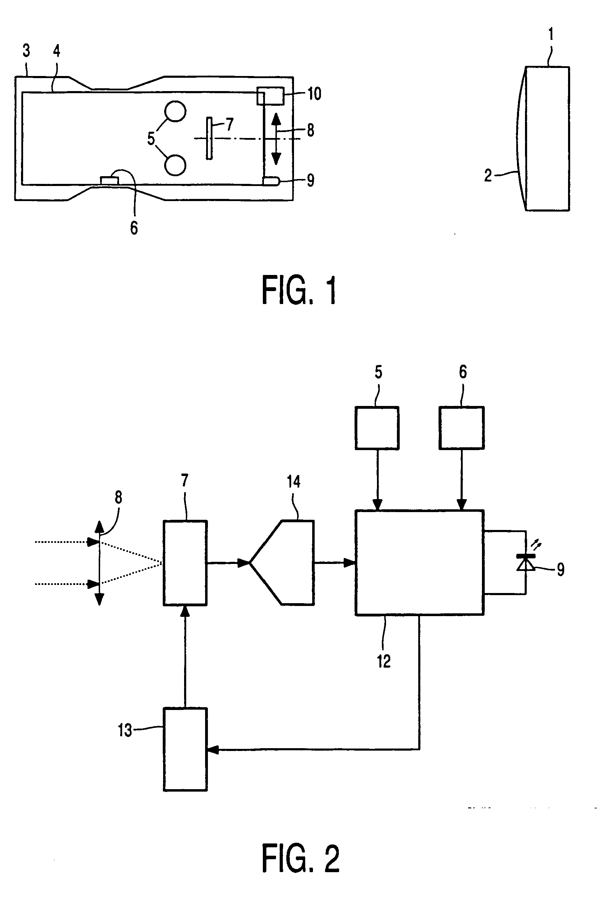

Figure 1 shows a television receiver 1 comprising a display screen 2, and a remote control 3. The remote control 3 comprises a circuit board 4 and buttons 5 which have the same function as the buttons of a computer mouse. Additionally, conventional remote control buttons may be provided, e.g. numerical keys, teletext keys etc. The remote control 3 further comprises a grip sensor 6 for detecting when the remote control is picked up by a user. Imaging optics 8 are capable of projecting an image of a remote object, e.g. the television receiver 1, onto an image sensor 7 which is placed on the circuit board 4. A LED (Light Emitting Diode) 9 is mounted on the circuit board 4 for transmitting infrared light signals to the television receiver 1. An auto-focus unit 10 is provided for establishing a sharp projection upon the image sensor 7 and for measuring the distance to the projected object.

Figure 2 shows a block diagram of the relevant elements of the remote control 3. An image of the display screen 2 is projected onto the image sensor 7, which is a matrix of photo-sensitive cells, e.g. photo-diodes or integrating photo-cells. The photo-sensitive cells (pixels) are scanned periodically by addressing them by means of a pixel addressing unit 13. The resultant electric signal is converted by an A/D converter 14 and transmitted to a signal processor 12 in digital form. The signal processor 12, constituting orientation means for detecting a relative movement with respect to a display apparatus to be controlled, is capable of extracting salient distinctive elements from the available information. Software algorithms for detecting such elements are known per se. For example, the signal processor 12 may look for transitions between light and dark areas whose dimensions and contrast values exceed a certain threshold. Suitable elements the signal processor 12 may look for are the corners of the display screen 2, a cursor or other elements of the displayed content. Alternatively, correlation techniques may be used for the extraction of salient elements. These techniques are known per se.

The coordinates of said elements are stored in a memory (not shown). By storing the coordinates of at least two elements, both translation along two coordinate axes and rotation can be detected. Periodically, e.g. every frame or averaged over a number of frames, the measured translation or rotation will be converted to appropriate commands for controlling the television receiver 1, and transmitted to the television receiver 1 by means of infrared signals generated by the LED 9, or by means of an alternative transmission method. The signal processor 12, or another dedicated circuit, generates the codes to be transmitted from the computed translation and rotation, together with the state of the buttons 5 and the grip sensor 6.

The grip sensor activates signal processor 12 when the remote control 3 is operated by the user. Upon activation an initialization routine is started which performs the following functions:

- Transmitting an initialization code to the television receiver 1, causing a cursor and/or menu to be activated.
- Capturing an image from the image sensor
- Determination of the coordinates of salient elements of the image, and computing relative translation or rotation by means of correlation techniques.

For the recognition of image elements it is not necessary to take all pixels into account. Only the pixels close to such an element need to be stored and processed, thus saving processing power. Dependent on the required response times, detected movements may be averaged over multiple measurements before transmitting corresponding commands to the television receiver 1.

The recognition of the display screen 2 may be enhanced by taking specific properties of the display screen 2 into account. Generally, displays are characterized by a specific refresh rate, which ranges from 25 Hz (classical TV) to 160 Hz. This refresh rate can be detected, and this can be used to determine which information on the image sensor 7 is obtained from the display screen 2. From this information the salient elements can then be extracted. Elements consist of light-dark transitions with a certain contrast and dimensions. For a reliable recognition at least a few pixels should be involved.

If the position of two elements at a time t is given by $(x0,y0)(t)$ and $(x1, y1)(t)$ respectively, translation and rotation with respect to point $(x0, y0)$ can be calculated by determining the coordinates of the two points at two subsequent points in time t0 and t1 as, respectively, $(x0, y0)(t0)$, $(x1, y1)(t0)$ and $(x0, y0)(t1)$, $(x1, y1)(t1)$. Now translation is defined as:

- $dx = x0(t1) - x0(t0)$
- $dy = y0(t1) - y0(t0)$

Rotation is defined as:

- $\Theta = \arctan((x1(t1) - x1(t0) - dx)/(y1(t1) - y1(t0) - dy))$.

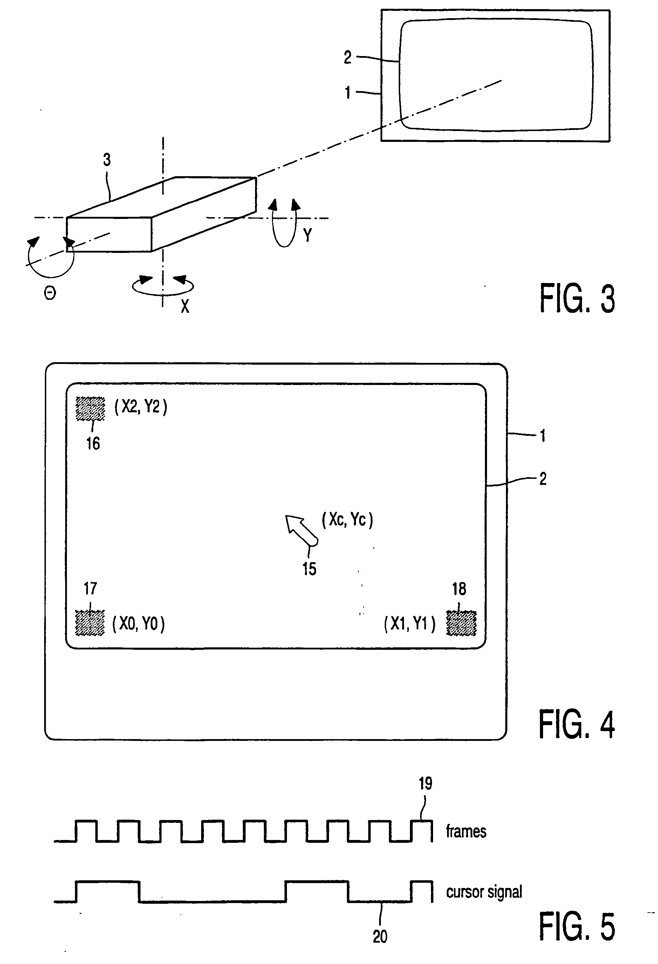

Figure 3 shows the various degrees of freedom of the remote control 3.

All measures discussed can be applied without adapting the software or hardware of the display apparatus to be controlled. Additional reliability and functionality may be obtained by adapting the displayed content on the display screen 2 in a predetermined way. For example, a cursor may be hard to detect within the unpredictable content of the displayed picture. This problem may be solved by periodically changing some properties of the cursor, e.g. its intensity. By switching the cursor on and off at regular times, e.g. every other refresh cycle, the detector is able to clearly distinguish the cursor from the displayed picture. By filtering over time, the cursor position can be determined reliably.

The absolute position with respect to the display screen 2 may be determined by comparing its position with the fixed positions of further elements. Figure 4 shows a cursor 15 having position $(Xc, Yc)$ and two elements 16 and 18 at positions $(X2,Y2)$ and $(X1,Y1)$ respectively. The presence of a third element 17 at position $(X0,Y0)$ will enhance the reliability of the computations. By choosing fixed positions for the further elements, e.g.

the corners of the display screen, the signal processor 12 is able to infer the screen diameter. The absolute position $(X,Y)$ of the cursor 15 is defined as:

$$X = xc/(x2 - x1)$$

$$Y = yc/(y2 - y1)$$

The periodical change of cursor properties may be modulated in order to transmit information from the display apparatus 1 to the remote control 3. For example, information related to the status of the display apparatus 1, or a desired change of sensitivity of the remote control 3, may be transferred to the remote control 3. Cursor modulation is achieved by controlling the periodic change with codes representing the information to be transmitted.

This is illustrated in Figure 5. The step function 19 represents the frame cycle, the high level representing the even frames, and the low level representing the odd frames. The step function 20 represents the cursor signal, the high level representing 'cursor on', and the low level representing 'cursor off. Techniques for encoding information are well known per se.

In summary, the invention relates to a remote control apparatus for controlling a display apparatus. The remote control comprises an image sensor and imaging optics for projecting an image, for example of the display screen, on the image sensor. If a user moves the remote control apparatus, the projected image will move accordingly. From the movement of the projected image, a relative movement of the remote control apparatus with respect to the display apparatus is deduced, and converted to control commands which are transmitted to the display apparatus.

Although the invention has been described with reference to particular illustrative embodiments, variants and modifications are possible within the scope of the claims.

The word 'comprising' does not exclude the presence of elements or steps other than those listed in a claim.

**Claims**

1. A remote control apparatus for controlling a display apparatus, comprising orientation means for detecting a relative movement of the remote control apparatus with respect to the display apparatus, the orientation means comprising an image sensor and imaging optics for projecting an image on the image sensor, and the orientation means being adapted to deduce said movement from a movement of the projected image **characterized in that** the remote control apparatus further comprises distance measuring means for measuring a distance to an object of which an image is projected on the image sensor, the orientation means being adapted to adjust said relative movement with respect to said distance.

**2.** A remote control apparatus as claimed in claim 1, **characterized in that** the remote control apparatus further comprises activation means for activating the orientation means in response to a user command or predetermined event.

**3.** A remote control apparatus as claimed in claim 1, **characterized in that** the orientation means are further adapted to recognize an image of the display apparatus.

**4.** A remote control apparatus as claimed in claim 3, **characterized in that** the orientation means are further adapted to store properties (dimensions, refresh rate) of the display apparatus.

**5.** A remote control apparatus as claimed in claim 3 or 4, **characterized in that** the orientation means are adapted to recognize an icon with predetermined properties on the display of the display apparatus.

**6.** A remote control apparatus as claimed in claim 5, **characterized in that** said predetermined properties comprise a periodic change of predetermined parameters (e.g. color, brightness).

**7.** A remote control apparatus as claimed in claim 6, **characterized in that** the remote control is adapted to decode status information related to the display apparatus from said periodic change.

**8.** A remote control apparatus as claimed in anyone of claims 3 to 7, **characterized in that** the orientation means are further adapted to determine a relative position of the remote control apparatus with respect to the display apparatus by deducing said relative position from the projected image of the display apparatus.

**9.** A system comprising a display apparatus and a remote control apparatus having the features of the remote control apparatus as defined in anyone of claims 5 to 7, **characterized in that** the display apparatus is adapted to display an icon with predetermined properties for enhancing the recognizability of an image of the display apparatus when projected onto the image sensor of the remote control apparatus.

**Patentansprüche**

**1.** Fernsteuergerät zur Steuerung einer Anzeigevorrichtung, mit Orientierungsmitteln zum Detektieren einer relativen Bewegung des Fernsteuergeräts gegenüber der Anzeigevorrichtung, wobei die Orientierungsmittel einen Bildsensor sowie eine Abbildungsoptik zum Projizieren eines Bildes auf den Bildsensor umfassen, und wobei die Orientierungsmittel so eingerichtet sind, dass sie die Bewegung von einer Bewegung des projizierten Bildes ableiten, **dadurch gekennzeichnet, dass** das Fernsteuergerät weiterhin Abstandsmessmittel umfasst, um einen Abstand zu einem Objekt zu messen, von dem ein Bild auf dem Bildsensor projiziert wird, wobei die Orientierungsmittel so eingerichtet sind, dass sie die relative Bewegung gegenüber dem Abstand abgleichen.

**2.** Fernsteuergerät nach Anspruch 1, **dadurch gekennzeichnet, dass** das Fernsteuergerät weiterhin Aktivierungsmittel umfasst, um die Orientierungsmittel in Reaktion auf eine Benutzeranweisung oder ein vorgegebenes Ereignis zu aktivieren.

**3.** Fernsteuergerät nach Anspruch 1, **dadurch gekennzeichnet, dass** die Orientierungsmittel weiterhin so eingerichtet sind, dass sie ein Bild der Anzeigevorrichtung erkennen.

**4.** Fernsteuergerät nach Anspruch 3, **dadurch gekennzeichnet, dass** die Orientierungsmittel weiterhin so eingerichtet sind, dass sie Eigenschaften (Dimensionen, Auffrischrate) der Anzeigevorrichtung speichern.

**5.** Fernsteuergerät nach Anspruch 3 oder 4, **dadurch gekennzeichnet, dass** die Orientierungsmittel so eingerichtet sind, dass sie ein Icon mit vorgegebenen Eigenschaften auf dem Display der Anzeigevorrichtung erkennen.

**6.** Fernsteuergerät nach Anspruch 5, **dadurch gekennzeichnet, dass** die vorgegebenen Eigenschaften eine periodische Änderung vorgegebener Parameter (z.B. Farbe, Helligkeit) umfassen.

**7.** Fernsteuergerät nach Anspruch 6, **dadurch gekennzeichnet, dass** die Fernsteuerung so eingerichtet ist, dass sie auf die Anzeigevorrichtung bezogene Statusinformationen von der periodischen Änderung decodiert.

**8.** Fernsteuergerät nach einem der Ansprüche 3 bis 7, **dadurch gekennzeichnet, dass** die Orientierungsmittel weiterhin so eingerichtet sind, dass sie eine relative Position des Fernsteuergeräts gegenüber der Anzeigevorrichtung durch Ableiten der relativen Position von dem projizierten Bild der Anzeigevorrichtung ermitteln.

9. System mit einer Anzeigevorrichtung und einem Fernsteuergerät mit den Merkmalen des Fernsteuergeräts, wie in einem der Ansprüche 5 bis 7 definiert, **dadurch gekennzeichnet, dass** die Anzeigevorrichtung so eingerichtet ist, dass sie ein Icon mit vorgegebenen Eigenschaften darstellt, um die Erkennbarkeit eines Bildes der Anzeigevorrichtung bei Projizieren desselben auf den Bildsensor des Fernsteuergeräts zu verbessern.

## Revendications

1. Dispositif de commande à distance pour commander un dispositif d'affichage, comprenant des moyens d'orientation pour détecter un mouvement relatif du dispositif de commande à distance par rapport au dispositif d'affichage, les moyens d'orientation comprenant un capteur d'image et une optique d'imagerie pour projeter une image sur le capteur d'image et les moyens d'orientation étant adaptés de manière à déduire ledit mouvement d'un mouvement de l'image projetée, **caractérisé en ce que** le dispositif de commande à distance comprend encore des moyens de mesure de distance pour mesurer une distance jusqu'à un objet dont une image est projetée sur le capteur d'image, les moyens d'orientation étant adaptés de manière à ajuster ledit mouvement relatif par rapport à ladite distance.

2. Dispositif de commande à distance selon la revendication 1, **caractérisé en ce que** le dispositif de commande à distance comprend encore des moyens d'activation pour activer les moyens d'orientation en réponse à une instruction d'utilisateur ou à un événement prédéterminé.

3. Dispositif de commande à distance selon la revendication 1, **caractérisé en ce que** les moyens d'orientation sont encore adaptés de manière à reconnaître une image du dispositif d'affichage.

4. Dispositif de commande à distance selon la revendication 3, **caractérisé en ce que** les moyens d'orientation sont encore adaptés de manière à stocker des propriétés (dimensions, taux de rafraîchissement) du dispositif d'affichage.

5. Dispositif de commande à distance selon la revendication 3 ou selon la revendication 4, **caractérisé en ce que** les moyens d'orientation sont adaptés de manière à reconnaître une icône avec des propriétés prédéterminées sur l'affichage du dispositif d'affichage.

6. Dispositif de commande à distance selon la revendication 5, **caractérisé en ce que** lesdites propriétés prédéterminées comprennent un changement périodique de paramètres prédéterminés (par exemple, couleur, luminosité).

7. Dispositif de commande à distance selon la revendication 6, **caractérisé en ce que** le dispositif de commande à distance est adapté de manière à décoder, à partir dudit changement périodique, de l'information d'état qui est liée à l'appareil d'affichage.

8. Dispositif de commande à distance selon l'une quelconque des revendications précédentes 3 à 7, **caractérisé en ce que** les moyens d'orientation sont encore adaptés de manière à déterminer une position relative du dispositif de commande à distance par rapport au dispositif d'affichage en déduisant ladite position relative de l'image projetée du dispositif d'affichage.

9. Système comprenant un dispositif d'affichage et un dispositif de commande à distance ayant les particularités caractéristiques du dispositif de commande à distance, telles que définies dans l'une quelconque des revendications précédentes 5 à 7, **caractérisé en ce que** le dispositif d'affichage est adapté de manière à afficher une icône avec des propriétés prédéterminées pour renforcer le caractère reconnaissable d'une image du dispositif d'affichage lorsqu'elle est projetée sur le capteur d'image du dispositif de commande à distance.

FIG. 1

FIG. 2

FIG. 3

FIG. 4

FIG. 5

frames

cursor signal

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5644126 A
- EP 0767443 A
- JP 07121293 A
- EP 0838751 A
- US 5138304 A
- JP 07171799 A
- US 5535147 A

**Non-patent literature cited in the description**

- **Andrew Houghton ; Graham Rees ; Peter Ivey.** Measurement Science & Technology. IOP publishing Ltd, 1997, 611-617
- **Ichirou Yamagouchi ; Tadashige Fujita.** *Optical Engineering,* December 1991, vol. 30 (12), 1862-1868
- **Adolf W. Lohmann ; David Mendiovic ; Zeev Zalevsky.** *APPLIED OPTICS,* 01 October 1997, vol. 36 (28), 7204-7209
- **G.E. Hege ; H.J. Tiziani.** *Tech. Messen,* 1987, vol. 54 (6), 237-242